# EUROPEAN PATENT APPLICATION

(11) **EP 2 594 596 A1**
(43) Date of publication of application: **22.05.2013**
(21) Application number: 12184489.8
(22) Date of filing: 14.09.2012
(51) Int. Cl.: C08G 59/62, C08L 63/00, H01L 23/29

(54) **Epoxy resin composition for semiconductor encapsulation and semiconductor device using the same**

(30) Priority: 18.11.2011 JP 2011252847
(71) Applicant: NITTO DENKO CORPORATION, Osaka 567 (JP)
(72) Inventor: Sugimoto, Naoya, Ibaraki-shi, Osaka 567-8680 (JP); Ichikawa, Tomoaki, Ibaraki-shi, Osaka 567-8680 (JP); Iwashige, Tomohito, Ibaraki-shi, Osaka 567-8680 (JP); Yano, Satomi, Ibaraki-shi, Osaka 567-8680 (JP)
(74) Representative: Grünecker, Kinkeldey, Stockmair & Schwanhäusser

(57) **Abstract**

The present invention relates to an epoxy resin composition for semiconductor encapsulation, including the following components (A) to (F): (A) an epoxy resin; (B) a phenol resin; (C) a curing accelerator; (D) an inorganic filler; (E) a hydrotalcite compound; and (F) a carboxyl group-containing wax having an acid value of 10 to 100 mg KOH/g.

## Description

### FIELD OF THE INVENTION

The present invention relates to an epoxy resin composition for semiconductor encapsulation that is excellent in reliability under high temperature and high humidity conditions and in continuous moldability, and a semiconductor device using the same.

### BACKGROUND OF THE INVENTION

Semiconductor devices such as transistors, ICs and LSIs have hitherto been manufactured by encapsulating a variety of semiconductor elements, using plastic packages, for example, heat-curable epoxy resin compositions, from the viewpoint of protecting the semiconductor elements from external environmental factors and making it possible to handle the semiconductor elements.

One of important requirements for epoxy resin compositions for semiconductor encapsulation is reliability under high temperature and high humidity conditions. That is to say, high temperature or high humidity provides a good environment for ionic impurities such as chloride ions contained in the epoxy resin compositions to act easily. For this reason, wires on semiconductor elements are prone to corrosion, and the conventional epoxy resin compositions for semiconductor encapsulation suffer from poor reliability under high temperature and high humidity conditions. The ionic impurities such as the chloride ions contained in the epoxy resin compositions, causing poor reliability under high temperature and high humidity conditions are formed by glycidyl etherification of phenols with epihalohydrins in the course of the production of epoxy resins. For example, conventional cresol novolak type epoxy resins have high solubility in solvents, so that purification by washing with water becomes possible. This makes it possible to obtain epoxy resins having a lower chlorine content (i.e. a higher purity). In contrast, low-viscosity crystalline epoxy resins used for a high degree of filling of inorganic fillers have low solubility in solvents, so that it has been difficult to obtain high-purity epoxy resins (see Patent Document 1).

Accordingly, in order to capture the ionic impurities causing poor reliability under high temperature and high humidity conditions and being contained in the epoxy resin compositions, it has been proposed to use ion scavengers such as hydrotalcite compounds, bismuth oxides and yttrium oxides (for example, see Patent Documents 2, 3 and 4).

Patent Document 1: JP-A-2-187420
Patent Document 2: JP-A-11-240937
Patent Document 3: JP-A-9-157497
Patent Document 4: JP-A-9-169830

### SUMMARY OF THE INVENTION

However, in the case where the above-mentioned ion scavengers are used, the use of the ion scavengers raises a new problem of having an adverse effect on continuous moldability, such as the occurrence of sticking of the epoxy resin compositions as an encapsulating material to molds or the occurrence of stains on surfaces of packages formed.

The invention has been made in view of such circumstances, and an object of the invention is to provide an epoxy resin composition for semiconductor encapsulation that is excellent not only in reliability under high temperature and high humidity conditions, but also in continuous moldability, and a semiconductor device using the same.

Namely, the present invention relates to the following items 1 to 7.
1. An epoxy resin composition for semiconductor encapsulation, including the following components (A) to (F):
   (A) an epoxy resin;
   (B) a phenol resin;
   (C) a curing accelerator;
   (D) an inorganic filler;
   (E) a hydrotalcite compound; and
   (F) a carboxyl group-containing wax having an acid value of 10 to 100 mg KOH/g.
2. The epoxy resin composition for semiconductor encapsulation according to item 1, in which the epoxy resin as the component (A) is an epoxy resin having a biphenyl group.
3. The epoxy resin composition for semiconductor encapsulation according to item 1 or 2, in which the hydrotalcite compound as the component (E) is a compound represented by the following general formula (1):

   [L²⁺₁₋ₓQ³⁺ₓ(OH)₂]^{x+}[(Aⁿ⁻)_{x/n·}mH₂O]^{x}- (1)

   in which L is a divalent metal ion, Q is a trivalent metal ion, Aⁿ⁻ is an n-valent anion, x satisfies 0.2≤x≤0.33, and m satisfies 0≤m≤3.5.
4. The epoxy resin composition for semiconductor encapsulation according to any one of items 1 to 3, in which the wax as the component (F) is a mixture of oxidized polyethylene and a long-chain aliphatic acid.
5. The epoxy resin composition for semiconductor encapsulation according to any one of items 1 to 4, in which the component (E) is contained in an amount of from 0.02 to 2.0% by weight of the whole of the epoxy resin composition.
6. The epoxy resin composition for semiconductor encapsulation according to any one of items 1 to 5, in which the component (F) is contained in an amount of from 0.02 to 2.0% by weight of the whole of the epoxy resin composition.

7. A semiconductor device comprising a semiconductor element encapsulated with the epoxy resin composition for semiconductor encapsulation according to any one of items 1 to 6.

The present inventors have made intensive studies in order to obtain a material for semiconductor encapsulation having excellent continuous moldability, in addition to excellent reliability under high temperature and high humidity conditions. In the course of the studies, the inventors have made intensive studies in the cause of deterioration of continuous moldability. As a result, it has been ascertained that a hydrotalcite compound used as an ion scavenger reacts with a wax incorporated as a release agent to form a reaction product, which causes the occurrence of sticking of the encapsulating material to a mold or the occurrence of stains on a surface of a package. On the basis of this finding, studies have been further made. As a result, it has been found that when a hydrotalcite compound (component (E)) is used as the ion scavenger and a carboxyl group-containing wax that gives an acid value within a specific range is used as the release agent in combination with each other, the above-mentioned wax does not react with the hydrotalcite compound because of its acid value within the specific range, resulting not only in realization of excellent reliability under high temperature and high humidity conditions, but also in decreased occurrence of sticking of the encapsulating material to the mold or decreased occurrence of stains on the surface of the package to impart excellent performance also with respect to continuous moldabiliy, thus arriving at the invention.

As described above, the invention provides an epoxy resin composition for semiconductor encapsulation containing a hydrotalcite compound (component (E)) and a specific wax (component (F)), in combination with an epoxy resin (component (A)), a phenol resin (component (B)), a curing accelerator (component (C)) and an inorganic filler (component (D)), and a semiconductor device encapsulated using the same. For this reason, the epoxy resin composition has not only excellent reliability under high temperature and high humidity conditions, but also excellent continuous moldability. Accordingly, the use of the epoxy resin composition for semiconductor encapsulation of the invention makes it possible to produce the semiconductor device having high reliability at good productivity.

Then, when an epoxy resin having a biphenyl group is used as the epoxy resin (component (A)), a more excellent effect of improving moldability and reliability is obtained.

Further, when a mixture of oxidized polyethylene and a long-chain aliphatic acid is used as the specific wax (component (F)), an effect of suppressing deterioration in appearance of a resin for encapsulation (cured body), namely the occurrence of stains on the surface of the package, becomes more effective.

### DETAILED DESCRIPTION OF THE INVENTION

Embodiments for carrying out the invention will be described below.

An epoxy resin composition for semiconductor encapsulation of the invention (hereinafter also abbreviated to as an "epoxy resin composition") includes an epoxy resin (component (A)), a phenol resin (component (B)), a curing accelerator (component (C)), an inorganic filler (component (D)), a hydrotalcite compound (component (E)) and a specific wax (component (F)), and has generally a powder form, a granular form or a tablet form obtained by tableting the powder.

### <A: Epoxy Resin>

Various epoxy resins can be used as the epoxy resin (component (A)). Examples thereof include bisphenol A type epoxy resins, phenol novolak type epoxy resins, cresol novolak type epoxy resins, biphenyl type epoxy resins and triphenylmethane type epoxy resins. These epoxy resins may be used either alone or in combination of two or more thereof. Of these, biphenyl type epoxy resins or low hygroscopicity type epoxy resins in which lower alkyl groups are added to phenyl rings are preferably used from the viewpoints of reliability and moldability. As such epoxy resins, those having an epoxy equivalent of 150 to 250 and a softening point or melting point of 50 to 130°C are preferred.

### <B: Phenol Resin>

The phenol resin (component (B)) used in combination with the epoxy resin (component (A)) functions as a curing agent for the epoxy resin (component (A)), and means all monomers, oligomers and polymers having two or more phenolic hydroxyl groups in one molecule thereof. Examples thereof include phenol novolak resins, cresol novolak resins, biphenyl type novolak resins, triphenylmethane type phenol resins, naphthol novolak resins, phenol aralkyl resins and biphenyl aralkyl resins. These phenol resins may be used either alone or in combination of two or more thereof.

It is preferred to blend the epoxy resin (component (A)) with the phenol resin (component (B)) in a proportion enough to cure the epoxy resin (component (A)), specifically, in such a proportion that the equivalent of the total hydroxyl groups in the phenol resin (component (B)) with respect to one equivalent of the epoxy group in the epoxy resin (component (A)) is from 0.6 to 1.2, and more preferably from 0.7 to 1.0.

### <C: Curing Aceelerator>

Various compounds having an curing accelerating action can be used as the curing accelerator (component (C)) used in combination with the epoxy resin (component (A)) and the phenol resin (component (B)), and examples thereof include phosphorus compounds, amine-based curing accelerators, quaternary ammonium salts, imidazoles and boron compounds. These may be used either alone or in combination of two or more thereof.

Specific examples of the phosphorus compounds include phosphine compounds, for example, organophosphines such as triphenylphosphine, diphenyl(p-tolyl)phosphine, tris(alkylphenyl)phosphines, tris(alkoxyphenyl)phosphines, tris(alkyl·alkoxyphenyl)phosphines, tris(dialkylphenyl)phosphines, tris(trialkylphenyl)phosphines, tris(tetraalkylphenyl)phosphines, tris(dialkoxyphenyl)phosphines, tris(trialkoxyphenyl)phosphines, tris(tetraalkoxyphenyl)phosphines, trialkylphosphines, dialkylarylphosphines and alkyldiarylphosphines; complexes of these phosphine compounds and organoborons; compounds having intramolecular polarization obtained by addition of maleic anhydride, quinone compounds such as 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone and phenyl-1,4-benzoquinone, or compounds having one or more π bonds such as diazophenylmethane, to these phosphine compounds; compounds having intramolecular polarization obtained by reacting these phosphine compounds with halogenated phenol compounds such as 4-bromophenol, 3-bromophenol, 2-bromophenol, 4-chlorophenol, 3-chlorophenol, 2-chlorophenol, 4-iodophenol, 3-iodophenol, 2-iodophenol, 4-bromo-2-methylphenol, 4-bromo-3-methylphenol, 4-bromo-2,6-dimethylphenol, 4-bromo-3,5-dimethylphenol, 4-bromo-2,6-di-tert-butylphenol, 4-chloro-1-naphthol, 1-bromo-2-naphthol, 6-bromo-2-naphthol and 4-bromo-4'-hydroxybiphenyl, followed by dehydrohalogenation thereof; and tetra-substituted phosphonium salts such as tetraphenylphosphonium tetraphenylborate, tetraphenylphosphonium tetra-p-tolylborate, tetraphenylphosphonium thiocyanate, tetraphenylphosphonium dicyanamide, tetraphenylphosphonium acetate, tetraphenylphosphonium tetrafluoroborate, tetraphenylphosphonium hexafluoroantimonate, p-tolyltriphenylphosphonium tetra-p-tolylborate, tetra-p-tolylphosphonium tetraphenylborate, tetra-p-tert-butylphenylphosphonium tetraphenylborate and tetra-p-methoxyphenylphosphonium tetraphenylborate.

Specific examples of the amine-based curing accelerators include cyclic amidine compounds of diazabicycloalkenes such as 1,5-diazabicyclo[4.3.0]nonane-5 and 1,8-diazabicyclo[5.4.0]undecene-7; derivatives thereof; cyclic amidinium salts such as phenol novolac salts thereof; compounds having intramolecular polarization obtained by addition of maleic anhydride, quinone compounds such as 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone and phenyl-1,4-benzoquinone, or compounds having one or more π bonds such as diazophenylmethane, to these phosphine compounds; tertiary amines such as pyridine, triethylamine, triethylenediamine, benzylmethylamine, triethanolamine, dimethylaminoethanol and tris(dimethylaminomethyl)phenol; and derivatives thereof.

Specific examples of the imidazoles include 2-methyl imidazole, 2-phenyl imidazole, 2-phenyl-4-methyl imidazole, 2-phenyl-4-methyl-5-hydroxymethyl imidazole and 2-heptadecyl imidazole.
These various curing accelerators may be used either alone or in combination of two or more thereof.

The content of the curing accelerator (component (C)) is preferably set to 1.0 to 12.0% by weight, and more preferably to 3.0 to 10.0% by weight, based on the weight of the phenol resin (component (B)).

### <D: Inorganic Filler>

As the inorganic filler (component (D)) used in combination with the components (A) to (C), there are used various fillers. Examples thereof include silica powders such as fused silica powders and crystalline silica powders, alumina powders and talc powders. These inorganic fillers may be used in any form, for example, in a crushed, spherical or ground form. These inorganic fillers may be used either alone or in combination of two or more thereof. Above all, the silica powders are preferably used in that the linear expansion coefficient of a cured product obtained can be reduced. Of the silica powders, spherical fused silica powders are particularly preferably used in view of their high filling capacity and high flowability.

Further, in view of improved flowability, it is preferred to use the inorganic filler (component (D)) having an average particle diameter of 5 to 40 µm. The average particle diameter of the inorganic filler (component (D)) can be measured, for example, using a commercially available laser diffraction/scattering particle size distribution analyzer, for a measurement sample randomly taken out from a population.

Then, the content of the inorganic filler (component (D)) is preferably set to 70 to 95% by weight, and particularly preferably to 85 to 92% by weight of the whole of the epoxy resin composition. That is to say, when the content of the inorganic filler (component (D)) is too small, the viscosity of the epoxy resin composition excessively decreases to tend to cause poor appearance (occurrence of voids) in molding. Meanwhile, when the content thereof is too large, the flowability of the epoxy resin composition is deteriorated to tend to cause a flow of wires and incomplete filling.

### <E: Hydrotalcite Compound>

The hydrotalcite compound (component (E)) used in combination with the components (A) to (D) has a function as an ion scavenger. The hydrotalcite compounds include, for example, a hydrotalcite compound represented by the following general formula (1):

[L²⁺₁₋ₓQ³+ₓ(OH)₂]^{x+}[(Aⁿ⁻)_{x/n}·mH₂O]^{x-} (1)

in which L is a divalent metal ion, Q is a trivalent metal ion, Aⁿ⁻ is an n-valent anion, x satisfies 0.2≤x≤0.33, and m satisfies 0≤m≤3.5.

In the above-mentioned formula (1), L is a divalent metal ion, and specific examples thereof include Mg²⁺, Fe²⁺, Zn²⁺, Ca²⁺, Ni²⁺, Co²⁺ and Cu²⁺. Further, Q is a trivalent metal ion, and specific examples thereof include Al³⁺, Fe³⁺ and Mn³⁺. Then, Aⁿ⁻ is an n-valent anion, and specific examples thereof include OH⁻, SO₄²⁻, CO₃²⁻ and NO³⁻.

The hydrotalcite compound represented by the above-mentioned formula (1) exhibits high adsorptive capacity, and has high adsorptive capacity to chlorine ions that deteriorate reliability under high temperature and high humidity conditions. Accordingly, it contributes to improvement of reliability under high temperature and high humidity conditions in proportion to the amount thereof blended. However, when the amount of the hydrotalcite compound blended is excessively increased, continuous moldability is deteriorated. In view of such characteristics, the amount of the hydrotalcite compound blended is preferably set to 0.02 to 2.0% by weight, and more preferably to 0.05 to 0.5% by weight of the whole of the epoxy resin composition.

Further, in order to decrease adsorbed water and improve ion-exchange capacity, there may be used one obtained by burning the hydrotalcite compound represented by the above-mentioned general formula (1) at high temperature (for example, at about 500°C).

From the viewpoints of economic efficiency and easy availability, such a hydrotalcite compound is preferably a compound in which L is Mg²⁺, Q is Al³⁺ and Aⁿ⁻ is CO₃²⁻, in formula (1). Specific examples of the hydrotalcite compounds satisfying such formula (1) include DHT-4A, DHT-4A-2, DHT-4C and DHT-4H manufactured by Kyowa Chemical Industry Co., Ltd. and IXE-700F manufactured by Toagosei Co., Ltd.

### <F: Specific Wax>

The specific wax (component (F)) used in combination with the components (A) to (E) is a carboxyl group-containing wax having an acid value of 10 to 100 mg KOH/g, and there is used, for example, a oxidized polyethylene-based wax or a long-chain aliphatic acid having the above-mentioned specific acid value. Such waxes may be used either alone or in combination with two or more thereof.

The carboxyl group-containing wax used in the invention generally has a polar group including a carboxyl group and a non-polar group including a long carbon chain, so that the polar group is oriented on the resin cured product side and conversely the non-polar group is oriented on the mold side in molding, thereby functioning as a release agent.

The oxidized polyethylene-based wax having the specific acid value used in the invention may be any, as long as it satisfies the above-mentioned acid value, and examples thereof include an oxidized polyethylene produced by a low pressure polymerization process, an oxidized polyethylene produced by a high pressure polymerization process and an oxidized high density polyethylene polymer. These oxidized polyethylene-based waxes may be used either alone or in combination of two or more thereof. Above all, in view of releasability, an oxide of a high density polyethylene polymer is preferably used. Specific examples thereof include Licowax PED 136, 153 and 521 manufactured by Clariant (Japan) K.K.

Examples of the long-chain aliphatic acids used in the invention include hexadecanoic acid having 16 carbon atoms (namely, palmitic acid), heptadecanoic acid having 17 carbon atoms (namely, margaric acid), octadecanoic acid having 18 carbon atoms (namely, stearic acid), eicosanoic acid having 20 carbon atoms (namely, arachic acid), docosanoic acid having 22 carbon atoms (namely, behenic acid), tetracosanoic acid having 24 carbon atoms (namely, lignoceric acid), hexacosanoic acid having 26 carbon atoms (namely, cerotic acid), heptacosanoic acid having 27 carbon atoms (namely, carboselic acid), octacosanoic acid having 28 carbon atoms (namely, montanoic acid), triacontanoic acid having 30 carbon atoms (namely, melissic acid), dotriacontanoic acid having 32 carbon atoms (namely, laceroic acid), tritriacontanoic acid having 33 carbon atoms (namely, ceromelissic acid or pricinic acid), tetratriacontanoic acid having 34 carbon atoms (namely, geddic acid) and pentatriacontanoic acid having 35 carbon atoms (namely, ceroplastic acid). These aliphatic acids may be used either alone or in combination with two or more thereof. Above all, in terms of bleeding properties, carboxylic acids having 30 or more carbon atoms are preferably used. Specific examples thereof include Unicid 700 and 550 manufactured by Baker Hughes Incorporated.

The drop point of the carboxyl group-containing wax (component (F)) having a specific acid value used in the invention is preferably from 100 to 140°C, and more preferably from 110 to 130°C. The drop point can be measured by a method in accordance with ASTM D127 (2004). Specifically, it is measured as a temperature at the time when the melted wax first drops from a metallic nipple. In the following, the drop point can be measured by a similar method. Then, when the drop point of the wax (component (F)) is within the above-mentioned range, the carboxyl group-containing wax (component (F)) having a specific acid value has excellent heat stability and excellent continuous moldability. Then, when the drop point is within the above-mentioned range, the polyethylene-based wax is fully melted in the case when the epoxy resin composition is cured, thereby resulting in nearly uniform dispersion of the carboxyl group-containing wax (component (F)) having a specific acid value in the resin cured product. For this reason, segregation of the carboxyl group-containing wax (component (F)) having a specific acid value on the surface of the resin cured product is suppressed, which makes it possible to decrease stains on a mold or sticking thereof to a mold.

The acid value of the carboxyl group-containing wax (component (F)) having a specific acid value used in the invention is required to be from 10 to 100 mg KOH/g, and more preferably from 15 to 80 mg KOH/g. The acid value exerts an influence on compatibility with the resin cured product. In the case where the acid value is too small, continuous moldability is deteriorated by stains, whereas in the case where the acid value is too large, not only stains occurs, but also the wax reacts with the hydrotalcite compound (component (E)) described above to cause deterioration of reliability. Incidentally, the acid value is measured and represented as the number of milligrams (mg) of potassium hydroxide (KOH) required for neutralizing free aliphatic acids contained in 1 g of the wax.

In the specific wax (component (F)) used in the invention, the oxidized polyethylene-based wax and the long-chain aliphatic acid are preferably used in combination, from the viewpoint of suppressing deterioration in appearance of the resin cured product (formation of stains). The ratio of the oxidized polyethylene-based wax and the long-chain aliphatic acid used in combination in this case (oxidized polyethylene-based wax/long-chain aliphatic acid) is set preferably to 1/9 to 9/1, and more preferably to 3/7 to 7/3, by weight ratio.

The content of the specific wax (component (F)) is preferably from 0.02 to 2.0% by weight, more preferably from 0.1 to 1.0% by weight, and particularly preferably from 0.1 to 0.5% by weight of the whole of the epoxy resin composition.

### <Other Various Additives>

In the epoxy resin composition according to the invention, various additives such as a silane coupling agent, a flame retardant, a flame retardant aid, a stress reducing agent, a pigment such as carbon black, a colorant and a tackifier may be appropriately incorporated, in addition to the components (A) to (F), as needed. These various additives are incorporated in amounts appropriately set within the range not impairing the effects of the invention.

As the silane coupling agent, there is suitably used, for example, one having two or more alkoxy groups. Specific examples thereof include 3-methacryloxypropyltrimethoxysilane, β-(3,4-epoxycyclohexyl)ethyltrimethoxysilane, γ-glycidoxypropyltrimethoxysilane, γ-mercaptopropyltrimethoxysilane, γ-(2-aminoethyl)aminopropyltrimethoxysilane, γ-mercaptopropylmethyldimethoxysilane, γ-anilinopropyltrimethoxysilane and hexamethyldisilazane. These silane coupling agents may be used either alone or in combination of two or more thereof.

Examples of the flame retardants include novolak type brominated epoxy resins and metal hydroxides such as magnesium hydroxide. As the flame retardant aid, there is used, for example, diantimony trioxide or diantimony pentoxide. These flame retardant aids may be used either alone or in combination of two or more thereof.

Examples of the stress reducing agents include butadiene rubbers such as methyl acrylate-butadiene-styrene copolymers and methyl methacrylate-butadiene-styrene copolymers, and silicone compounds. These stress reducing agents may be used either alone or in combination of two or more thereof.

The epoxy resin composition for semiconductor encapsulation according to the invention may be produced, for example, by the following procedure. That is to say, the above-mentioned components (A) to (F) and optionally one or more other additives are appropriately blended by a conventional method and melt kneaded in a heated state with a kneader such as a mixing roll. Subsequently, the kneaded mixture is solidified by cooling at room temperature, and thereafter pulverized by a known means, followed by tableting as needed. Through such a series of steps, the desired epoxy resin composition can be produced.

### <Semiconductor Device>

A method for encapsulating a semiconductor element using the epoxy resin composition thus obtained is not particularly limited, and can be performed by a known molding process such as usual transfer molding to obtain the semiconductor device. It is also possible that a powder pulverized to a granular state is applied to a compression molding process, without undergoing the above-mentioned tableting process. The semiconductor devices thus obtained include semiconductor devices such as ICs and LSIs.

### EXAMPLES

Examples will be described below in combination with Comparative Examples. However, the invention should not be construed as being limited to these Examples.

First, the following respective components were prepared.

### [Epoxy Resin]

Biphenyl type epoxy resin (manufactured by Japan Epoxy Resin Co., Ltd., YX-4000, epoxy equivalent: 192, melting point: 105°C)

### [Phenol Resin]

Biphenyl aralkyl type phenol resin (manufactured by Meiwa Plastic Industries, Ltd., MH7851 SS, hydroxyl equivalent: 203, softening point: 65°C)

### [Curing Accelerator]

2-Phenyl-4-methyl-5-hydroxymethylimidazole manufactured by Shikoku Chemicals Corporation)

### [Inorganic Filler]

Spherical fused silica powder (average particle diameter: 13 µm)

### [Pigment]

Carbon black

### [Flame Retardant]

Magnesium hydroxide

### [Silane Coupling Agent]

3-Methacryloxypropyltrimethoxysilane

### [Hydrotalcite Compound e1]

DHT-4A (manufactured by Kyowa Chemical Industry Co., Ltd.)
[Hydrotalcite Compound e2]
DHT-4A-2 (manufactured by Kyowa Chemical Industry Co., Ltd.)
[Hydrotalcite Compound e3]
DHT-4C (manufactured by Kyowa Chemical Industry Co., Ltd.)
[Hydrotalcite Compound e4]
DHT-4H (manufactured by Kyowa Chemical Industry Co., Ltd.)
[Hydrotalcite Compound e5]
IXE-700F (manufactured by Toagosei Co., Ltd.)

### [Wax f1] (Example)

Long-chain aliphatic acid (manufactured by Baker Hughes Incorporated., Unicid 700 (drop point: 110°C, acid value: 63 mg KOH/g))
[Wax f2] (Example)
Long-chain aliphatic acid (manufactured by Baker Hughes Incorporated., Unicid 550 (drop point: 101°C, acid value: 79 mg KOH/g))
[Wax f3] (Example)
Oxidized polyethylene wax (manufactured by Clariant (Japan) K.K., Licowax PED 136, (drop point: 111°C, acid value: 60 mg KOH/g))
[Wax f4] (Example)
Oxidized polyethylene wax (manufactured by Clariant (Japan) K.K., Licowax PED 153, (drop point: 120°C, acid value: 25 mg KOH/g))
[Wax f5] (Example)
Oxidized polyethylene wax (manufactured by Clariant (Japan) K.K., Licowax PED 521, (drop point: 105°C, acid value: 17 mg KOH/g))
[Wax f6] (Comparative Example)
Long-chain aliphatic acid (manufactured by Baker Hughes Incorporated., Unicid 350 (drop point: 92°C, acid value: 120 mg KOH/g))
[Wax f7] (Comparative Example)
Oxidized polyethylene wax (manufactured by Toyo Petrolite Co., Ltd., Petrolite C-8500, (drop point: 95°C, acid value: 9 mg KOH/g))
[Wax f8] (Comparative Example)
Saturated alcohol (manufactured by Baker Hughes Incorporated., Unilin 700 (drop point: 105°C, acid value: 0 mg KOH/g))
[Wax f9] (Comparative Example)
Polyethylene wax (manufactured by Clariant (Japan) K.K., Licowax PE 520, (drop point: 120°C, acid value: 0 mg KOH/g))

### [Examples 1 to 15 and Comparative Examples 1 to 4]

The respective components shown in Tables 1 to 3 described later were blended in the ratios shown in the same Tables, and melt-kneaded using a twin-screw kneader at 100°C for 2 minutes. Then, the molten product was cooled and thereafter pulverized to obtain a desired powdery epoxy resin composition.

Using each of the epoxy resin compositions of Examples and Comparative Examples thus obtained, the gelation time thereof was measured by the following method. Further, using each of the epoxy resin compositions, the continuous moldability thereof was evaluated according to the following method. Furthermore, reliability of each of the epoxy resin compositions under high temperature and high humidity conditions was evaluated by the following method. In addition, package stains in the above-mentioned evaluation of continuous moldability was also evaluated. These results are shown in Tables 1 to 3 described later.

### <Gelation Time>

About 0.1 to 0.5 g of the epoxy resin composition was placed on a hot flat plate at 175°C, and melted while stirring with a glass rod having a diameter of 1.5 mm. Time until resin cobwebbing has not been observed was taken as gelation time (second). Taking into consideration curability, it is generally proper that the gelation time is 60 sec or less.

### [Continuous Moldability]

A molding mold was previously cleaned. A package was encapsulated with each of the epoxy resin compositions obtained in the Examples and the Comparative Examples by transfer molding (molding temperature: 175°C, and molding time: 90 seconds), and this procedure was repeated. The molding shot number until the epoxy resin composition is stuck to the molding mold (sticking) was counted. Then, a molding shot in which the sticking occurred was defined as a stop shot, and the number thereof was described.
Incidentally, the above-mentioned package includes a ball grid array (BGA) substrate (35 mm x 35 mm x 0.5 mm in thickness) and a semiconductor element (10 mm x 10 mm x 0.3 mm in thickness) mounted thereon.

### [Reliability under High Temperature and High Humidity Conditions]

On the semiconductor device manufactured as described above, a HAST test (unsaturated pressurized steam test: no bias voltage) was conducted in an environment of 130°C and 85% RH. The resistance value thereof was measured after the HAST test. When the resistance value was increased by 10% or more, the semiconductor device was judged to be poor (disconnected). The time when this disconnection occurred during the HAST test was described as the life time (hr) of reliability under high temperature and high humidity conditions.

### [Package Stains]

In the above-mentioned evaluation of continuous moldability, the number of molding shots until stains were visually confirmed on the surface of the package was counted and described.

**[Table 1]**

| (parts by weight) | | | | | | | | |
|---|---|---|---|---|---|---|---|---|
| | | Example | | | | | | |
| | | 1 | 2 | 3 | 4 | 5 | 6 | 7 |
| Epoxy Resin (A) | | 4.84 | 4.84 | 4.84 | 4.84 | 4.84 | 4.84 | 4.84 |
| Phenol Resin (B) | | 5.17 | 5.17 | 5.17 | 5.17 | 5.17 | 5.17 | 5.17 |
| Curing Accelerator (C) | | 0.1 | 0.1 | 0.1 | 0.1 | 0.1 | 0.1 | 0.1 |
| Inorganic Filler (D) | | 88.79 | 88.79 | 88.79 | 88.79 | 88.79 | 88.79 | 88.79 |
| Hydrotalcite Compound e (E) | | 0.1 | 0.1 | 0.1 | 0.1 | 0.1 | 0.1 | 0.1 |
| Wax (F) | f1 | 0.3 | - | - | - | - | - | - |
| | f2 | - | 0.3 | - | - | - | 0.2 | 0.1 |
| | f3 | - | - | 0.3 | - | - | - | - |
| | f4 | - | - | - | 0.3 | - | - | - |
| | f5 | - | - | - | - | 0.3 | 0.1 | 0.2 |
| Pigment | | 0.5 | 0.5 | 0.5 | 0.5 | 0.5 | 0.5 | 0.5 |
| Flame Retardant | | 0.1 | 0.1 | 0.1 | 0.1 | 0.1 | 0.1 | 0.1 |
| Silane Coupling Agent | | 0.1 | 0.1 | 0.1 | 0.1 | 0.1 | 0.1 | 0.1 |
| Gelation Time (sec) | | 48 | 49 | 48 | 50 | 50 | 50 | 48 |
| Reliability under High Temperature and High Humidity Conditions Life Time (hr) | | 1018 | 1008 | 1020 | 1035 | 1025 | 1028 | 1023 |
| Continuous Moldability (shots) | | 319 | 297 | 303 | 264 | 251 | 325 | 311 |
| Package Stains (shots) | | 223 | 209 | 210 | 188 | >251 | >325 | >316 |

**[Table 2]**

| (parts by weight) | | | | | | | | | |
|---|---|---|---|---|---|---|---|---|---|
| | | Example | | | | | | | |
| | | 8 | 9 | 10 | 11 | 12 | 13 | 14 | 15 |
| Epoxy Resin (A) | | 4.84 | 4.84 | 4.84 | 4.84 | 4.84 | 4.84 | 4.84 | 4.84 |
| Phenol Resin (B) | | 5.17 | 5.17 | 5.17 | 5.17 | 5.17 | 5.17 | 5.17 | 5.17 |
| Curing Accelerator (C) | | 0.1 | 0.1 | 0.1 | 0.1 | 0.1 | 0.1 | 0.1 | 0.1 |
| Inorganic Filler (D) | | 88.79 | 88.79 | 88.79 | 88.79 | 88.79 | 88.79 | 88.79 | 88.79 |
| Hydrotalcite Compound (E) | e2 | 0.1 | - | - | - | 0.1 | 0.1 | 0.05 | 0.3 |
| | e3 | - | 0.1 | - | - | - | - | - | - |
| | e4 | - | - | 0.1 | - | - | - | - | - |
| | e5 | - | - | - | 0.1 | - | - | - | - |
| Wax f1 (F) | | 0.3 | 0.3 | 0.3 | 0.3 | 0.2 | 0.4 | 0.3 | 0.3 |
| Pigment | | 0.5 | 0.5 | 0.5 | 0.5 | 0.5 | 0.5 | 0.5 | 0.5 |
| Flame Retardant | | 0.1 | 0.1 | 0.1 | 0.1 | 0.1 | 0.1 | 0.1 | 0.1 |
| Silane Coupling Agent | | 0.1 | 0.1 | 0.1 | 0.1 | 0.1 | 0.1 | 0.1 | 0.1 |
| Gelation Time (sec) | | 48 | 49 | 48 | 50 | 47 | 51 | 48 | 49 |
| Reliability under High Temperature and High Humidity Conditions Life Time (hr) | | 1018 | 1008 | 1020 | 1035 | 1020 | 1009 | 851 | 1107 |
| Continuous Moldability (shots) | | 319 | 297 | 303 | 264 | 309 | 330 | 339 | 251 |
| Package Stains (shots) | | 223 | 209 | 210 | 188 | 228 | 202 | 233 | 180 |

**[Table 3]**

| (parts by weight) | | | | | |
|---|---|---|---|---|---|
| | | Comparative Example | | | |
| | | 1 | 2 | 3 | 4 |
| Epoxy Resin (A) | | 4.84 | 4.84 | 4.84 | 4.84 |
| Phenol Resin (B) | | 5.17 | 5.17 | 5.17 | 5.17 |
| Curing Accelerator (C) | | 0.1 | 0.1 | 0.1 | 0.1 |
| Inorganic Filler (D) | | 88.79 | 88.79 | 88.79 | 88.79 |
| Hydrotalcite Compound e1 (E) | | 0.1 | 0.1 | 0.1 | 0.1 |
| Wax (F) | f6 | 0.3 | - | - | - |
| | f7 | - | 0.3 | - | - |
| | f8 | - | - | 0.3 | - |
| | f9 | - | - | - | 0.3 |
| Pigment | | 0.5 | 0.5 | 0.5 | 0.5 |
| Flame Retardant | | 0.1 | 0.1 | 0.1 | 0.1 |
| Silane Coupling Agent | | 0.1 | 0.1 | 0.1 | 0.1 |
| Gelation Time (sec) | | 48 | 48 | 48 | 48 |
| Reliability under High Temperature and High Humidity Conditions Life Time (hr) | | 215 | 1020 | 1019 | 1021 |
| Continuous Moldability (shots) | | 93 | 155 | 29 | 22 |
| Package Stains (shots) | | 65 | 108 | 19 | 16 |

The above-mentioned results reveal that the gelation time of all the epoxy resin compositions of Examples was proper and that the excellent evaluation results were obtained also for continuous moldability and reliability under high temperature and high humidity conditions, which shows that the epoxy resin compositions for semiconductor encapsulation also excellent in practicality were obtained. In particular, in Examples 6 and 7 in which the oxidized polyethylene wax and the long-chain aliphatic acid were used in combination as the wax components, not only reliability under high temperature and high humidity conditions of the epoxy resin compositions was excellent, but also the extremely excellent results were obtained for continuous moldability and package stains evaluation.

In contrast, the epoxy resin compositions of Comparative Examples using the waxes having an acid value too small or too large, departing from the specific range, were significantly poor in the evaluation of continuous moldability and package stains. It is therefore apparent that no epoxy resin composition excellent in both of continuous moldability and reliability under high temperature and high humidity conditions was obtained.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2011-252847 filed on November 18, 2011, and the contents are incorporated herein by reference.
All references cited herein are incorporated by reference herein in their entirety.

The epoxy resin composition for semiconductor encapsulation according to the invention exhibits excellent continuous moldability and excellent reliability under high temperature and high humidity conditions, and is useful as a material for encapsulation in various semiconductor devices.

## Claims

1. An epoxy resin composition for semiconductor encapsulation, comprising the following components (A) to (F):
(A) an epoxy resin;
(B) a phenol resin;
(C) a curing accelerator;
(D) an inorganic filler;
(E) a hydrotalcite compound; and
(F) a carboxyl group-containing wax having an acid value of 10 to 100 mg KOH/g.

2. The epoxy resin composition for semiconductor encapsulation according to claim 1, wherein the epoxy resin as the component (A) is an epoxy resin having a biphenyl group.

3. The epoxy resin composition for semiconductor encapsulation according to claim 1 or 2, wherein the hydrotalcite compound as the component (E) is a compound represented by the following general formula (1):
[L²⁺₁₋ₓQ³⁺ₓ(OH)₂]^{x+}[(Aⁿ⁻)_{x/n}·mH₂O]^{x-} (1)
in which L is a divalent metal ion, Q is a trivalent metal ion, Aⁿ⁻ is an n-valent anion, x satisfies 0.2≤x≤0.33, and m satisfies 0≤m≤3.5.

4. The epoxy resin composition for semiconductor encapsulation according to any one of claims 1 to 3, wherein the wax as the component (F) is a mixture of oxidized polyethylene and a long-chain aliphatic acid.

5. The epoxy resin composition for semiconductor encapsulation according to any one of claims 1 to 4, wherein the component (E) is contained in an amount of from 0.02 to 2.0% by weight of the whole of the epoxy resin composition.

6. The epoxy resin composition for semiconductor encapsulation according to any one of claims 1 to 5, wherein the component (F) is contained in an amount of from 0.02 to 2.0% by weight of the whole of the epoxy resin composition.

7. A semiconductor device comprising a semiconductor element encapsulated with the epoxy resin composition for semiconductor encapsulation according to any one of claims 1 to 6.
